(19) **Europäisches Patentamt**
**European Patent Office**
**Office européen des brevets**

(11) **EP 1 947 468 A1**

(12) **EUROPEAN PATENT APPLICATION**
published in accordance with Art. 158(3) EPC

(43) Date of publication:
**23.07.2008 Bulletin 2008/30**

(51) Int Cl.:
***G01R 33/02*** (2006.01) ***G01R 33/025*** (2006.01)

(21) Application number: **06841683.3**

(22) Date of filing: **07.11.2006**

(86) International application number:
**PCT/ES2006/000611**

(87) International publication number:
**WO 2007/054592 (18.05.2007 Gazette 2007/20)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **08.11.2005 ES 200502717**
**19.07.2006 ES 200601913**

(71) Applicant: **Zertan, S.A.**
**31132 Villatuerta (Navarra) (ES)**

(72) Inventors:
• **DIEZ GARCIA, Sergio**
**E-31151 Obanos (Navarra) (ES)**
• **LANDATXE ZUGARRAMURDI, Jose Luis**
**E-20120 Hernani (Guipuzcoa) (ES)**

(74) Representative: **Cabinet Plasseraud**
**52 rue de la Victoire**
**75440 Paris Cedex 09 (FR)**

(54) **DISTURBANCE ELIMINATION SYSTEM FOR INDUCTIVE SENSORS**

(57)    The invention relates to a disturbance elimination system for inductive sensors for monitoring the movement of mobile objects, including an inductive element formed by two magnetically-opposed identical half-coils (L2 and L3) which are arranged in parallel with one another and coplanar to the movement plane of a magnetic element (1) provided on the mobile element to be monitored, facing a point through which the moving magnetic element (1) passes.

Fig.3

EP 1 947 468 A1

**Description**

Field of the Art

The present invention is related to monitoring the movement of mechanisms in machines or apparatus by means of using an inductive sensor, proposing a system which allows canceling out the inductive disturbances caused by magnetic fields outside the detection system and which can cause poor operation thereof.

State of the Art

The use of devices for monitoring the movement of certain mechanisms, such as the motor, the ABS or the gear box of vehicles, and other applications is known, as described for example in Spanish patent ES 200501503, such devices using inductive sensors formed by a coil in front of which a mobile magnetic element (magnet or the like) passes which is capable of altering the flow present in said coil, inducing a small electromotive force or electrical voltage therein which is treated and amplified by means of an electronic circuit which consequently generates digital pulses in accordance with the passage of the mobile element in which the magnetic element is fixed.

In the mentioned inductive sensors, the variation of the magnetic flow caused by the passage of the mobile element and the corresponding electromotive force generated by it are very small when the passage speed of the mobile element is slow, such that the electromotive force induced by the mobile element is comparable in magnitude to the electromotive force induced by other magnetic fields present in the space for placing the sensor (which can be caused by motors, actuators, electrovalves or any electric-electronic mechanism through which currents variable over time circulate), which even though they can be considered uniform in volume where the sensor is located, they are however generally variable over time and therefore can cause a disturbing electromotive force.

In addition, the use of opposing coils is known, which coils, upon being subjected to a common alternating field, counteract their induction effects, which allows obtaining a measurement effect, for example in order to determine the contents of a magnetic material in an object made of nonmagnetic material, as described for example in Spanish patent ES 465,446.

Object of the Invention

According to the invention a system is proposed which allows simply solving the problem of the outside disturbances influencing the space for applying an inductive sensor in order to achieve that the function of said sensor is effective.

This system object of the invention consists of forming the inductive sensor applied with two identical half-coils, which are arranged electrically in series and magnetically opposed, said parallel and coplanar half-coils being placed in the movement plane of the mobile magnetic element of the sensor, in front of a position where said mobile magnetic element passes.

An assembly is thus obtained in which the electromotive forces induced in the half-coils by the influencing magnetic fields are counteracted, such that when the magnetic flows influencing both half-coils are identical, the induced electromotive force resulting from the assembly is nil.

The electromotive force induced by the outside magnetic fields, which only vary over time, is therefore identical in both half-coils and therefore is canceled out, whereas the electromotive force caused by the mobile magnetic element is different in the two half-coils, since the position of said magnetic element varies with respect to the two half-coils during the movement, whereby a resulting electromotive force is obtained due to the influence of the passage of said mobile magnetic element, allowing the monitoring of its movement.

By means of a suitable adjustment of the geometric and magnetic properties of the component elements, the system can further be adapted so that the positive or negative half-waves of both half-coils of the sensor are electrically added together, therefore the ratio of the signal of the induced electromotive force, which is obtained by the influence of the mobile magnetic element, is optimized with respect to the influence of the disturbances.

In the event that the disturbance field is not completely uniform in the space occupied by the half-coils of the sensor, such effect can also be counteracted, acting on the cores of the half-coils, such that the output signal of the sensor in the absence of movement of the mobile magnetic element is nil.

According to a particular constructive embodiment of the system, the two coils of the inductive sensor system are incorporated on a common core by means of two windings formed from a single wire wound in two axially consecutive sections with opposite winding directions.

The common core on which the coils are formed in this case is configured with a parallelepiped shape, for example from a die-cut sheet or strip, said core preferably being arranged with the plane of its larger faces in a perpendicular position with respect to the mobile mechanism in which the magnetic element of the sensor formed by a magnet is located.

An assembly and an arrangement are thus obtained with which the influence of the disturbing magnetic fields outside the system, which have a uniform spatial distribution in the environment of the sensor, is canceled out in the assembly of the opposing coils, whereas the magnet arranged on the mobile mechanism generates the variable electromotive forces in the coils, depending on the variation of its position with respect to said coils during the course of the movement, such that the difference of the electromotive forces generated in the two coils causes a signal which can be transformed into a pulse corresponding with each passage of the magnet in front of the coils, such that depending on the pulses an equivalence of the movement of the mechanism subjected to monitoring can be determined.

The sensor thus formed can virtually be arranged in a planar space, therefore requiring a very small space between the arrangement of the coils and the applied mobile mechanism, whereas since the two coils of the sensor are wound on a common core, the influence of the parasitic magnetic fields is much more uniform on the two coils than in the solution with coils on separate cores and therefore the resulting dissymmetries can easily be canceled out by moving the common core according to the shaft of the windings, facilitating the reduction of the influence of the interference signal.

The parallelepiped core of the coils is also very low-cost since it can be obtained by simple die-cutting using a sheet metal or metal flat bar.

For that reason the mentioned system object of the invention has advantageous features, acquiring its own identity and preferable character for the function for which it is intended.

Description of the Drawings

Figure 1 shows a diagram of the functional arrangement of a conventional inductive sensor affected by a disturbance field.

Figure 2 shows two comparative graphs of the electromotive forces induced in the coil of the sensor of the previous figure by the magnetic element mobile of the sensor and by the disturbances, and of the electromotive force resulting from the sum of the previous ones.

Figure 3 is a diagram of the functional arrangement of an inductive sensor according to the object of the invention affected by a disturbance field.

Figure 4 is a perspective depiction of the embodiment of said sensor object of the invention with the component half-coils placed in parallel.

Figure 5 shows the graphs of the electromotive forces induced by the disturbances in the half-coils of the sensor and of the electromotive force resulting from the corresponding sum.

Figure 6 shows the graphs of the electromotive forces induced by the mobile magnetic element in the half-coils of the sensor and of the electromotive force resulting from the corresponding sum.

Figure 7 is a diagram of the arrangement of the half-coils of the sensor of the invention according to an opposite connection.

Figure 8 is a diagram of the arrangement of the half-coils of the sensor of the invention with the winding in the opposite direction.

Figure 9 shows a diagram of the functional arrangement of an inductive sensor according to the object of the invention with the half-coils on a common core.

Figure 10 is a schematic depiction of the operation of said sensor of the previous figure.

Detailed Description of the Invention

The object of the invention relates to a system for canceling out the effect of the disturbances caused by external influences on the inductive sensors which are used to monitor the movements of mechanisms, using an arrangement which allows canceling out the influence of the disturbances by outside elements.

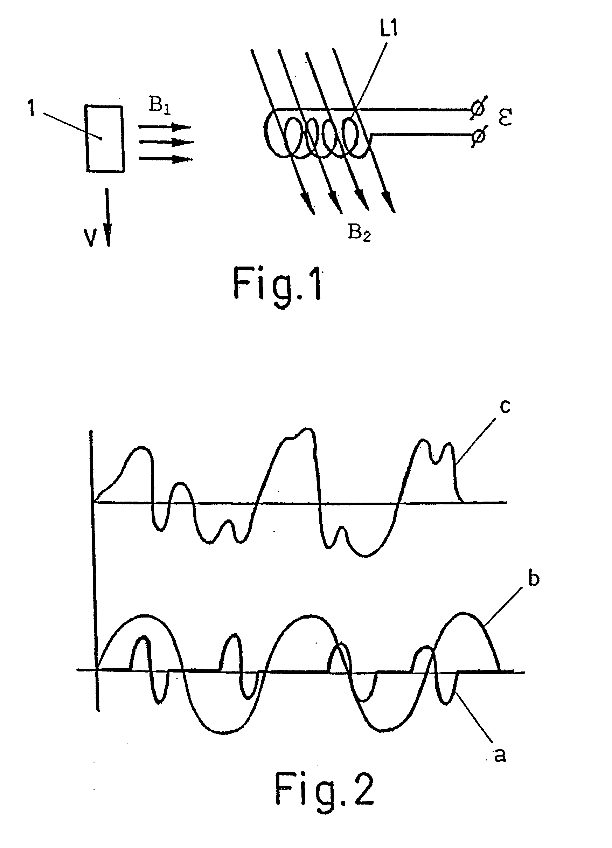

A conventional inductive sensor of the type indicated (Figure 1) consists of a coil (L1), which is arranged opposite the mobile element to be monitored, being incorporated in said mobile element a magnetic element (1), which can be any type of magnetic conductor, which upon passing in front of the coil (L1) alters the magnetic flow present therein, inducing an electromotive force or electrical voltage in said coil (L1), such that by amplifying that signal by means of an electronic circuit digital pulses are generated in accordance with the movement of the mobile element in which the magnetic element (1) is incorporated.

In the places for applying the mentioned inductive sensors there are however usually outside elements, such as motors, actuadores, electrovalves, etc., generating magnetic influences, such that the coil (L1) is affected by the influence of the magnetic field (B1) of the magnetic element (1) upon passing in front of said coil (L1) and by the influence of the magnetic field (B2) of the outside elements.

The influence of the magnetic element (1) on the coil (L1) depends on the speed (V) of the movement of said magnetic element (1), insofar as the influence of the outside elements is variable over time, both influences causing respective induced electromotive forces in the coil (L1), the curves of which are shown (a and b) in Figure 2, such that said electromotive forces are added together, giving rise to a resulting electromotive force ($\varepsilon$) corresponding to the curve (c) shown in Figure 2.

The influence of the field (B2) of the outside elements therefore forms a disturbance influencing the action of the sensor, being able to distort said action to the point of making the provided data unusable when the electromotive force induced by the outside elements has a magnitude similar to the electromotive force induced by the magnetic element (1).

This is due to the fact that the resulting electromotive force ($\varepsilon$) of the sensor of Figure 1 corresponding to the curve (c) of Figure 2, is the sum of the electromotive forces ($\varepsilon_1$ and $\varepsilon_2$) induced by the magnetic element (1) and the outside elements, corresponding to the curves (a and b) of Figure 2, according to the formula:

$$\varepsilon = - d(\Phi_1 + \Phi_2)_{L1} / d(t)$$

wherein $\Phi_1$ and $\Phi_2$ are the flows of the magnetic fields $B_1$ and $B_2$ of the diagram of Figure 1.

In other words in this case, the signal ($\varepsilon_2$) caused by the disturbance field $B_2$, uniform in space but variable over time, is superimposed and mixed with the signal ($\varepsilon_1$) caused by the movement of the magnetic element (1), making it difficult or impossible to differentiate the passage of said magnetic element (1) in front of the coil (L1).

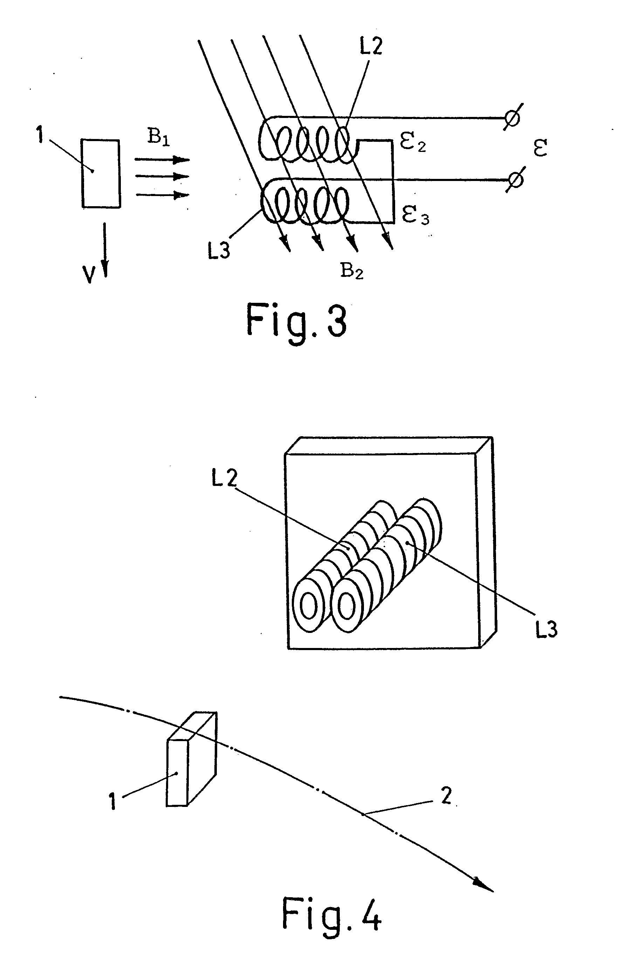

According to the system of the invention (Figures 3 and 4), the inductive sensor is formed with two half-coils (L2 and L3), which are arranged magnetically opposed, located parallel to one another and coplanar with respect to the movement plane (2) of the magnetic element (1), in an opposite position with respect to a passage point of said magnetic element (1).

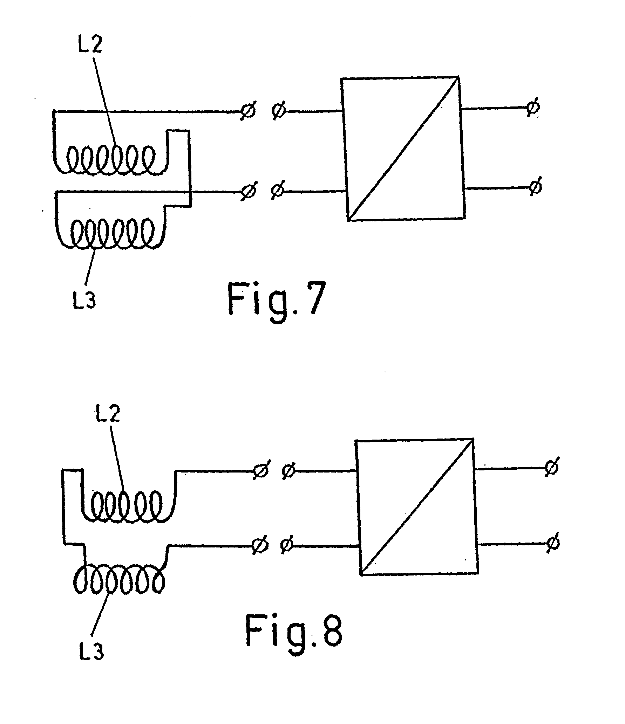

The two half-coils (L2 and L3) are arranged with their windings and the connections to one another and to the outer circuit such that the magnetic influences on said half-coils (L2 and L3) cause a mutual cancellation effect of the electromotive forces ($\varepsilon_{L2}$ and $\varepsilon_{L3}$) induced therein, the resulting electromotive force ($\varepsilon$) being nil in the terminals connected to the outside when the magnetic influence is the same on the two half-coils (L2 and L3). To that end the half-coils (L2 and L3) can be electrically connected in an opposing manner, as the example of Figure 7, or they can be arranged with their winding in opposite directions, as the example of Figure 8.

It is thus achieved that the electromotive force induced by the disturbing field (B$_2$) is nil or near zero in the output of the assembly of the half-coils (L2 and L3), only the electromotive force induced by the magnetic field (B$_1$) of the mobile magnetic element (1) being evident since the distance of the latter with respect to the half-coils (L2 and L3) is different and varies during the movement of the passage in front of same, such that the influence of said magnetic element (1) generates a different induction in both half-coils (L2 and L3), whereby the output of the assembly has a resulting electromotive force ($\varepsilon$) used as an actuation signal of the sensor in its operation.

This is due to the fact that since the induction effect generates an opposite electromotive force in both half-coils (L2 and L3), the resulting electromotive force ($\varepsilon$) of the assembly is the difference between the electromotive forces ($\varepsilon_{L2}$ and $\varepsilon_{L3}$) induced in said half-coils (L2 and L3), i.e.:

$$\varepsilon = \varepsilon_{L2} - \varepsilon_{L3}$$

$$\varepsilon = - d(\Phi_1 + \Phi_2)_{L2} / d(t) + d(\Phi_1 + \Phi_2)_{L3} / d(t)$$

wherein $\Phi_1$ and $\Phi_2$ are the flows of the magnetic fields $B_1$ and $B_2$ of the diagram of Figure 3.

However since the half-coils (L2 and L3) are identical and close to one another, the effect of the influence of the magnetic field (B$_2$) can be considered equal on both at any moment of time, whereby:

$$\varepsilon_{\Phi2} = - d(\Phi_2)_{L2} / d(t) + d(\Phi_2)_{L3} / d(t) = 0$$

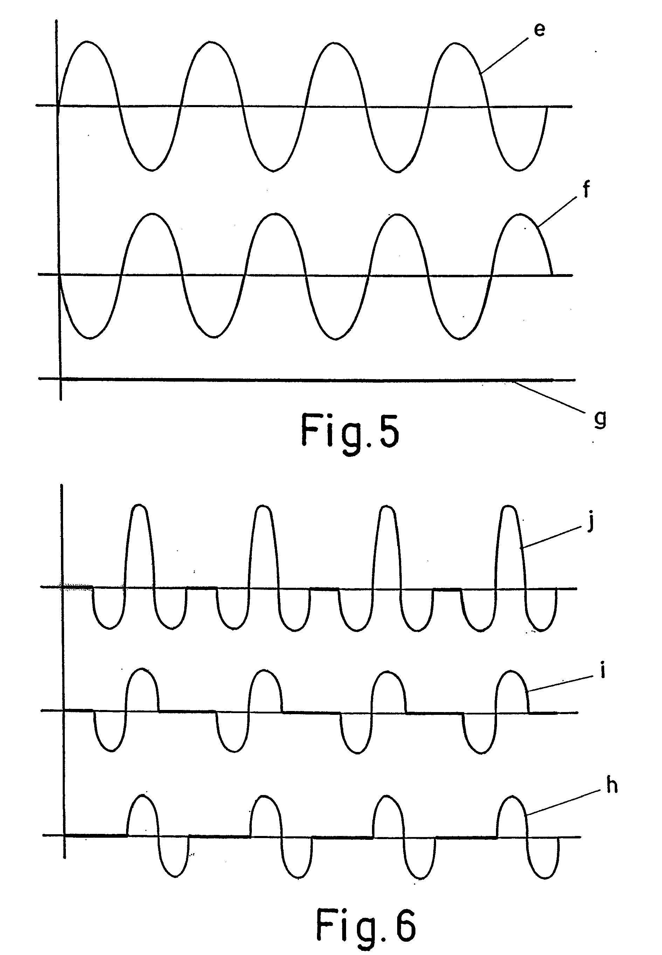

This is graphically reflected in Figure 5, in which the curves (e, f) correspond to the respective electromotive forces induced by the magnetic field (B$_2$) in the half-coils (L2 and L3), whereas the line (g) corresponds to the sum resulting from these two partial electromotive forces.

Insofar as the field (B$_1$), due to the distance between the half-coils (L2 and L3) and to the distance of the magnetic element (1) with respect to them, identical $\Phi_{1L2}$ and $\Phi_{1L3}$ flows do not occur in a given moment of time, whereby there are always voltage impulses in the output of the assembly which allow monitoring the passage of the magnetic element (1) and therefore the movement of the mobile element in which said magnetic element (1) is incorporated.

This is graphically reflect in Figure 6, in which the curves (h, i) correspond to the respective electromotive forces induced by the magnetic field ($B_1$) in the half-coils (L2 and L3), whereas the curve (j) corresponds to the sum resulting from these two partial electromotive forces.

By means of choosing the distance between the shafts of the half-coils (L2 and L3) and the distance between said half-coils (L2 and L3) and the mobile magnetic element (1), the positive or negative half-waves of both half-coils (L2 and L3) can be made to occur with a time lag such that their amplitudes are electrically added together, as shown in the depictions of Figures 5 and 6, whereby the effect of the resulting signal due to the induction of the magnetic element (1) is improved with respect to the effect of the disturbing induction by the outside elements, optimizing the result of the function of the sensor.

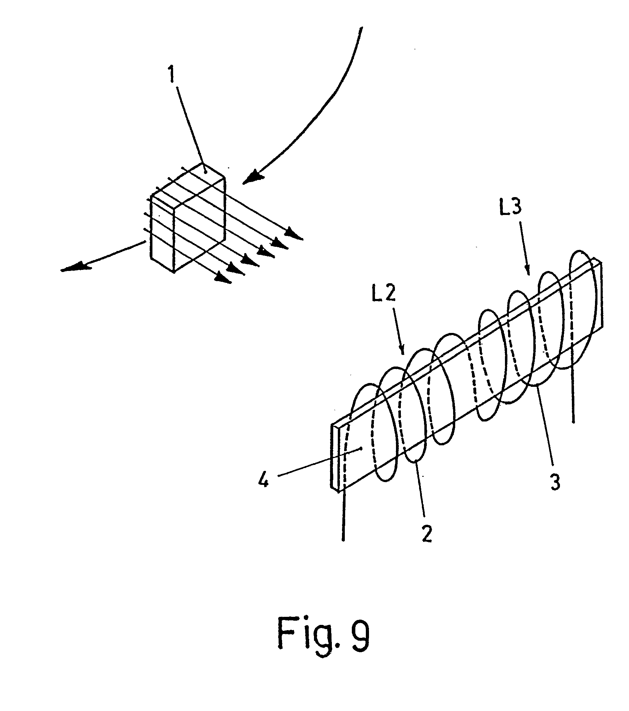

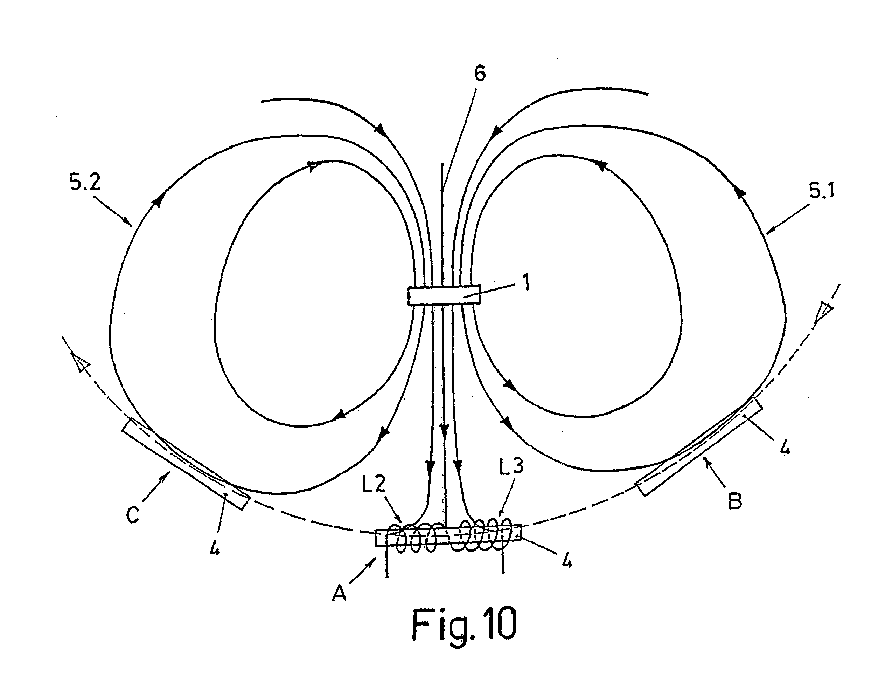

According to a constructive embodiment comprised in the same concept of the invention (Figures 9 and 10), the inductive sensor is formed with a core (4) made of magnetic conductive material, in an essentially planar parallelepiped shape, such that it can be obtained by die-cutting from a simple metal sheet without this formation being limiting.

Two axially consecutive half-coils (L2 and L3) are formed on said core (4) by means of respective windings (2 and 3) formed continuously with a single wire wound on two sections with opposite winding directions.

The sensor is completed with a magnetic element (1), such as a permanent magnet, which is incorporated on the mobile mechanism the movement of which is to be monitored with the sensor, the assembly of the half-coils (L2 and L3) being arranged in a position opposite an area of passage of said magnet (1), as it is carried by the application mechanism in its movement, in a longitudinal position with respect to that movement and preferably in an arrangement with the plane of the larger faces of the core (4) perpendicular to the mechanism in which the magnet (1) is incorporated, as depicted in Figure 9, although other positions are also possible.

In this case, as depicted in Figure 10, the magnetic field of the magnet (1) is distributed into two lines of force lobes (5.1 and 5.2) which are closed at the sides on the actual magnet (1) symmetrically with respect to a central line (6).

In these conditions, when the central line (6) of said magnetic field of the magnet (1) coincides with the longitudinal center of the distribution of the half-coils (L2 and L3) on the core (4), as in position (A) of the mentioned Figure 10, the lines of force of the lobes (5.1 and 5.2) equally affect both half-coils (L2 and L3), whereby creating by influence identical and opposite electromotive forces therein which cancel one another out, such that no signal is apparent between the terminals of the wire of the mentioned half-coils (L2 and L3).

However, during the movement of the magnet (1) when passing in front of the arrangement of the half-coils (L2 and L3), the lobes (5.1 and 5.2) affect each of the half-coils (L2 and L3) in a different way depending on the different distance of the magnet (1) from same, as in positions (B and C), therefore in said half-coils (L2 and L3) influences occur giving rise to the different electromotive forces, the difference of which is apparent between the terminals of the common wire of the half-coils (L2 and L3) with a considerable voltage signal, according to which the passage of the magnet (1) through that position can be counted and according to which an equivalence of the movement of the monitored mechanism in which the magnet (D) is arranged is determined.

The depiction of Figure 10 has been made, for illustrative reasons, as if the magnet (1) was in a fixed position and the assembly of the half-coils (L2 and L3) rotated around said magnet (1), which for the purpose of the explained operation is the same as if the assembly of the half-coils (L2 and L3) remains in a fixed position and the magnet (1) moves periodically passing in front of said position, as occurs when it is incorporated in a rotating mechanism, which is what normally occurs in practical applications of the sensor.

In this case, since the two half-coils (L2 and L3) are wound on a common core (1), the influence of the parasitic fields affecting the place of the installation is very uniform on the two half-coils (L2 and L3), and in any case the resulting residual dissymmetry can be cancelled out in a simple manner by slightly moving the core (4) according to the shaft of the half-coils (L2 and L3), therefore facilitating the reduction of the noise signal to a very low level.

## Claims

1. A disturbance elimination system for inductive sensors of the type comprising an inductive coil in front of which a magnetic element incorporated on a mobile element passes, the movement of which is to be monitored, **characterized in that** two identical half-coils (L2 and L3) are arranged in the function of an inductive coil, which half-coils are magnetically opposed, located parallel to one another and coplanar in their assembly with respect to the movement plane of the magnetic element (1) which is incorporated on the mobile element to be monitored.

2. A disturbance elimination system for inductive sensors according to claim 1, **characterized in that** the half-coils (L2 and L3) are placed with a separation between them and at a distance with respect to the magnetic element (1), so that the positive or negative half-waves of the respective inductions by the magnetic influences on said half-coils (L2 and L3) occur with a time lag such that their amplitudes are added together.

3.  A disturbance elimination system for inductive sensors according to claim 1, **characterized in that** the half-coils (L2 and L3) are electrically connected in series but in opposite directions.

4.  A disturbance elimination system for inductive sensors according to claim 1, **characterized in that** the half-coils (L2 and L3) are electrically connected in series, with their windings in opposite directions.

5.  A disturbance elimination system for inductive sensors according to claim 1, **characterized in that** the influence of the uniform magnetic fields ($B_2$) in the space for placing the half-coils (L2 and L3) causes identical inductions therein which cancel one another out.

6.  A disturbance elimination system for inductive sensors according to claim 1, **characterized in that** the influence of the magnetic field ($B_1$) of the magnetic element (1) is variable depending on the movement with respect to the half-coils (L2 and L3), causing different inductions therein giving rise to resulting pulses in the output of the assembly.

7.  A disturbance elimination system for inductive sensors according to claim 1, **characterized in that** the half-coils (L2 and L3) are arranged such that the output signal of the assembly of both is nil in the absence of movement of the magnetic element (1).

8.  A disturbance elimination system for inductive sensors according to claim 1, **characterized in that** the half-coils (L2 and L3) are incorporated on a common core (4) formed with a single conducting wire which is wound on said core (4) according to two axially consecutive windings (2 and 3) with reverse winding directions.

9.  A disturbance elimination system for inductive sensors according to claim 8, **characterized in that** the common core (4) on which the half-coils (L2 and L3) are formed is formed by a parallelepiped body made of magnetic conductive material, preferably having a planar configuration.

10. A disturbance elimination system for inductive sensors according to claims 8 and 9, **characterized in that** the assembly of the half-coils (L2 and L3) incorporated on the common core (4) is arranged in a longitudinal position with respect to the passing movement of a magnet (1) which is carried by the mobile mechanism to be monitored, said assembly of the half-coils (L2 and L3) preferably being located with the plane of the common core (4) perpendicular to the mentioned mobile mechanism in which the magnet (1) is incorporated.

$B_1$

1

V

L1

$B_2$

ε

## Fig.1

c

b

a

## Fig.2

Fig. 3

Fig. 4

Fig.5

Fig.6

Fig. 7

Fig. 8

Fig. 9

Fig.10

# INTERNATIONAL SEARCH REPORT

| | International application No. |
|---|---|
| | PCT/ ES 2006/000611 |

**A. CLASSIFICATION OF SUBJECT MATTER**

see extra sheet

According to International Patent Classification (IPC) or to both national classification and IPC

**B. FIELDS SEARCHED**

Minimum documentation searched (classification system followed by classification symbols)
G01R33/00, G01V3/00

Documentation searched other than minimum documentation to the extent that such documents are included in the fields searched

Electronic data base consulted during the international search (name of data base and, where practicable, search terms used)

CIBEPAT, EPODOC, WPI, INTERNET

**C. DOCUMENTS CONSIDERED TO BE   RELEVANT**

| Category* | Citation of document, with indication, where appropriate, of the relevant passages | Relevant to  claim No. |
|---|---|---|
| X | EP 0990919 A2 (ALPS ELECTRIC CO, LTD) | 1-10 |
| Y | 05.04.2000, | |
| | description, paragraphs 8 a 10; figure 8. | |
| Y | FR2687478 A1 (THOMSON CSF) 20.08.1993, the whole | 1-10 |
| | document. | |
| X | US 2004189293 A1 (CZIPOTT et al.) 30.09.2004, | 1-7 |
| Y | description, paragraphs 40, 42 and 55. | 8 |
| Y | US 5134370 A (JEFFERTS et al.) 28.07.1992, the whole | 8 |
| | document. | |
| X | FR 2223702 A1 (MISHIMA KOSAN CO. LTD) | 8 |
| | 25.10.1974, description, page 3, lines 9 a 17; | |
| | figure 2 | |
| X | Base de datos EPODOC in EPOQUE. JP 4301581 A | 8 |
| | (SHIMADZU CORP.) 26.10.1992, abstract, figures. | |

☐ Further documents are listed in the continuation of Box C.        ☒ See patent family annex.

| | | |
|---|---|---|
| * | Special categories of cited documents: | "T"  later document published after the international filing date or priority date and not in conflict with the application but cited to understand the principle or theory underlying the invention |
| "A" | document defining the general state of the art which is not considered to be of particular relevance. | |
| "E" | earlier document but published on or after the international filing date | |
| "L" | document which may throw doubts on priority claim(s) or which is cited to establish the publication date of another citation or other special reason (as specified) | "X"  document of particular relevance; the claimed invention cannot be considered novel or cannot be considered to involve an inventive step when the document is taken alone |
| "O" | document referring to an oral disclosure use, exhibition, or other means | "Y"  document of particular relevance; the claimed invention cannot be considered to involve an inventive step when the document is combined with one or more other documents , such combination being obvious to a person skilled in the art |
| "P" | document published prior to the international filing date but later than the priority date claimed | |
| | | "&"  document member of the same patent family |

| Date of the actual completion of the international search | Date of mailing of the international search report |
|---|---|
| | (21/03/07) |
| Name and mailing address of the ISA/ | Authorized officer |
| O.E.P.M. | |
| | P. López Sabater |
| Paseo de la Castellana, 75 28071 Madrid, España. | |
| Facsimile No.   34 91 3495304 | Telephone No. +34 91 349 53 85 |

Form PCT/ISA/210 (second sheet) (April 2005)

## INTERNATIONAL SEARCH REPORT

Information on patent family members

| International application No. |
| --- |
| PCT/ ES 2006/000611 |

| Patent document cited in the search report | Publication date | Patent family member(s) | Publication date |
| --- | --- | --- | --- |
| FR2687478 A | 20.08.1993 | NONE | |
| FR 2223702 A | 25.10.1974 | NL 7404137 A<br>DE 2414489 A | 01.10.1974<br>10.10.1974<br>10.10.1974 |
| US 2004189293 A | 30.09.2004 | US 2004147834 A<br>US 7106056 B<br>US 2004147833 A<br>US 2004169509 A<br>US 6956369 B<br>US 7154266 B<br>CA 2492265 A | 29.07.2004<br>12.09.2006<br>29.07.2004<br>02.09.2004<br>18.10.2005<br>26.12.2006<br>13.07.2005 |
| EP 0990919 A | 05.04.2000 | EP 19990307595<br>JP 2000111626 A | 27.09.1999<br>21.04.2000 |
| JP 4301581 A | 26.10.1992 | JP 3018540 B | 13.03.2000<br>13.03.2000<br>13.03.2000 |

Form PCT/ISA/210 (patent family annex) (April 2005)

## INTERNATIONAL SEARCH REPORT

<table>
<tr><td>International application No.</td></tr>
<tr><td>PCT/ ES 2006/000611</td></tr>
</table>

CLASSIFICATION OF SUBJECT MATTER

*G01R 33/02* (2006.01)
*G01R 33/025* (2006.01)

Form PCT/ISA/210 (extra sheeet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- ES 200501503

- ES 465446